(19) Europäisches Patentamt
European Patent Office
Office européen des brevets

(11) **EP 3 248 286 B1**

(12) **FASCICULE DE BREVET EUROPEEN**

(45) Date de publication et mention de la délivrance du brevet:
**25.09.2019 Bulletin 2019/39**

(51) Int Cl.:
***H03G 7/00*** *(2006.01)*

(21) Numéro de dépôt: **16701015.6**

(22) Date de dépôt: **19.01.2016**

(86) Numéro de dépôt international:
**PCT/EP2016/051029**

(87) Numéro de publication internationale:
**WO 2016/116453 (28.07.2016 Gazette 2016/30)**

(54) **AMPLIFICATEUR À RÉGLAGE DE NIVEAU SONORE AUTOMATIQUE**

VERSTÄRKER MIT EINSTELLUNG DES AUTOMATISCHEN SCHALLPEGELS

AMPLIFIER WITH ADJUSTMENT OF THE AUTOMATIC SOUND LEVEL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.01.2015 FR 1550405**

(43) Date de publication de la demande:
**29.11.2017 Bulletin 2017/48**

(73) Titulaire: **Devialet**
**75001 Paris (FR)**

(72) Inventeurs:
• **MENDES, Eduardo**
**26120 Chabeuil (FR)**
• **BERGÈRE, Julien**
**Mid levels**
**Hong Kong (CN)**
• **CALMEL, Pierre-Emmanuel**
**78150 Le Chesnay (FR)**

(74) Mandataire: **Lavoix**
**2, place d'Estienne d'Orves**
**75441 Paris Cedex 09 (FR)**

(56) Documents cités:
**US-A1- 2008 056 504     US-A1- 2014 369 527**

• **STONE MICHAEL A ET AL: "Effect of the speed of a single-channel dynamic range compressor on intelligibility in a competing speech task", THE JOURNAL OF THE ACOUSTICAL SOCIETY OF AMERICA, AMERICAN INSTITUTE OF PHYSICS FOR THE ACOUSTICAL SOCIETY OF AMERICA, NEW YORK, NY, US, vol. 114, no. 2, 1 août 2003 (2003-08-01), pages 1023-1034, XP012003584, ISSN: 0001-4966, DOI: 10.1121/1.1592160**
• **STONE MICHAEL A ET AL: "Comparison of different forms of compression using wearable digital hearing aids", THE JOURNAL OF THE ACOUSTICAL SOCIETY OF AMERICA, AMERICAN INSTITUTE OF PHYSICS FOR THE ACOUSTICAL SOCIETY OF AMERICA, NEW YORK, NY, US, vol. 106, no. 6, 1 décembre 1999 (1999-12-01), pages 3603-3619, XP012001391, ISSN: 0001-4966, DOI: 10.1121/1.428213**

EP 3 248 286 B1

**Description**

La présente invention concerne un procédé d'adaptation du gain de volume à appliquer par un amplificateur à au moins un signal audio à reproduire, en fonction du gain de volume désiré sélectionné par un utilisateur.

Les systèmes de diffusion audio procèdent à partir de sources audio très différentes et ayant des contenus différents (musique, paroles, sons divers). Le niveau sonore diffusé par un système audio dépend à la fois des signaux audio qui sont reproduits par le système de diffusion et du gain de volume désiré choisi par l'utilisateur et réglé manuellement sur l'amplificateur. A gain de volume désiré constant, suivant les signaux audio à diffuser, le niveau sonore perçu pourra être très différent. L'utilisateur est amené à constamment modifier le gain de volume désiré de manière à maintenir le niveau sonore perçu dans des limites désirées notamment lors d'audition d'une bande son de film ayant des changements de rythmes fréquents entre scènes d'actions et scènes de dialogues.

Dans la littérature, les méthodes proposées ont pour but de maintenir constant le niveau sonore moyen à gain de volume désiré constant quels que soient les signaux audio à reproduire.

Ces mécanismes de correction sont connus sous l'acronyme AVL pour « auto-volume leveller » en anglais.

La plupart des méthodes de l'état de la technique modifient le gain de volume désiré par l'utilisateur en le diminuant ou en l'augmentant d'une certaine quantité.

Les documents US5,666,430 et US6,195,438 décrivent des méthodes pour maintenir le niveau sonore moyen quasi constant.

Dans la littérature, il est souvent reporté des artefacts introduits par les systèmes de gain automatique (pompages, gains trop élevés lors de passages de silence...). Ces artefacts sont diminués par le réglage de temps d'attaque et de relâchement des actions sur le gain de volume désiré et la mise en place de seuils spécifiques difficiles à régler.

Dans l'état de la technique, les mécanismes mis en place ont vocation à maintenir le niveau sonore constant, ce qui dénature complètement le contenu musical d'une musique ou, dans le cas de l'écoute d'un film, ne différencie plus le niveau sonore lors d'un dialogue calme ou lors d'une scène d'action.

US 2014/369527 décrit une commande de plage dynamique utilisant une fonction de transfert de manière que la partie linéaire de la fonction de transfert soit ajustée au niveau sonore moyen du signal audio d'entrée.

L'invention a pour but de proposer un amplificateur capable de maintenir les dynamiques propres aux signaux audio sans imposer un niveau sonore moyen quasi constant, mais en laissant évoluer le niveau sonore dans des proportions agréables pour l'utilisateur.

A cet effet, l'invention, qui est définie dans les revendications 1 et 10, a pour objet un procédé du type précité, qui est exécuté par l'amplificateur et comporte des étapes de :

- calculer un niveau sonore lent total normalisé à partir du ou des signaux audio à reproduire ;
- calculer un gain de volume lent maximal et un gain de volume lent minimal comme le quotient du produit du gain de volume désiré par un gain lent maximal respectivement par un gain lent minimal divisé par le niveau sonore lent total normalisé ;
- déterminer un premier minimum entre le gain de volume désiré et le gain de volume lent maximal ;
- déterminer un second minimum entre le gain de volume désiré multiplié par un gain de volume maximal et le gain de volume lent minimal ;
- déterminer, en tant que gain de volume lent, le maximum des premier et second minima précédemment déterminés ;
- calculer le gain de volume appliqué en fonction du gain de volume lent.

La présente invention permet principalement de maintenir le niveau sonore entre une limite basse et une limite haute afin de maintenir la qualité d'écoute et la dynamique principale du signal audio.

Suivant des modes particuliers de réalisation le procédé d'adaptation du gain de volume à appliquer par un amplificateur comporte une ou plusieurs des caractéristiques suivantes :

- l'étape de calcul du niveau sonore lent total normalisé comporte, pour le ou chaque signal audio à reproduire, le calcul d'un niveau sonore lent propre au signal audio, comme la moyenne des niveaux du signal audio de chaque source sur une durée longue ;
- le procédé comporte au moins deux signaux audio à reproduire, et le niveau sonore lent total normalisé est une fonction de chacun des niveaux sonores lents ;
- la durée longue est supérieure à 1 seconde ;
- le gain de volume appliqué est le produit du gain de volume lent par un gain de volume crête de valeur inférieure ou égale à 1 dépendant des fluctuations du niveau sonore du ou de chaque signal sonore sur une durée courte strictement inférieure à la durée longue ;
- le calcul du gain de volume crête comporte les étapes de :

- calculer un niveau sonore rapide total normalisé à partir du ou des signaux à reproduire
- calculer un coefficient d'extension égal au quotient du produit du niveau sonore lent total normalisé par un gain de crête maximal divisé par le niveau sonore rapide total normalisé
- calculer le gain de volume crête comme le minimum du coefficient d'extension et de la valeur 1.

- l'étape de calcul du niveau sonore rapide total normalisé comporte, pour le ou chaque signal audio à reproduire, le calcul d'un niveau sonore rapide propre à chaque signal audio, comme la moyenne des niveaux du signal audio de la source sur la durée courte ;
- le procédé comporte au moins deux signaux audio à reproduire, et le niveau sonore rapide total normalisé est une fonction de chacun des niveaux sonores rapides ;
- la durée courte est inférieure à 1 seconde ;

L'invention a en outre pour objet un amplificateur comportant des moyens d'adaptation d'un gain de volume appliqué à au moins un signal audio à reproduire en fonction d'un gain de volume désiré sélectionné par un utilisateur comportant :

- des moyens de calcul d'un niveau sonore lent total normalisé à partir du ou des signaux audio à reproduire ;
- des moyens de calcul d'un gain de volume lent maximal et d'un gain de volume lent minimal comme le quotient du produit du gain de volume désiré par un gain lent maximal respectivement par un gain lent minimal divisé par le niveau sonore lent total normalisé ;
- des moyens pour déterminer un premier minimum entre le gain de volume désiré et le gain de volume lent maximal ;
- des moyens pour déterminer un second minimum entre le gain de volume désiré multiplié par un gain de volume maximal et le gain de volume lent minimal ;
- des moyens pour déterminer, en tant que gain de volume lent, le maximum des premier et second minima précédemment déterminés ;
- des moyens pour calculer le gain de volume appliqué en fonction du gain de volume lent.

L'invention sera mieux comprise à la lecture de la description qui va suivre, donnée uniquement à titre d'exemple, et fait en se référant aux dessins, sur lesquels :

- La figure 1 est une schématique d'une installation de restitution sonore selon l'invention ; et
- La figure 2 est un schéma bloc du procédé selon l'invention de calcul du gain de volume appliqué à partir du gain de volume désiré et des signaux à reproduire.

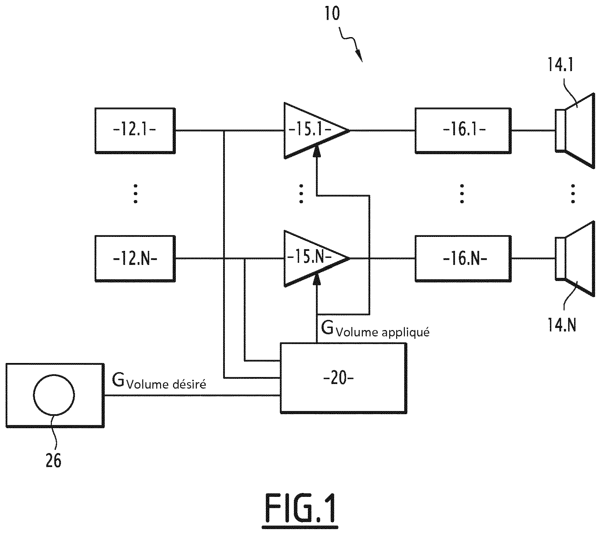

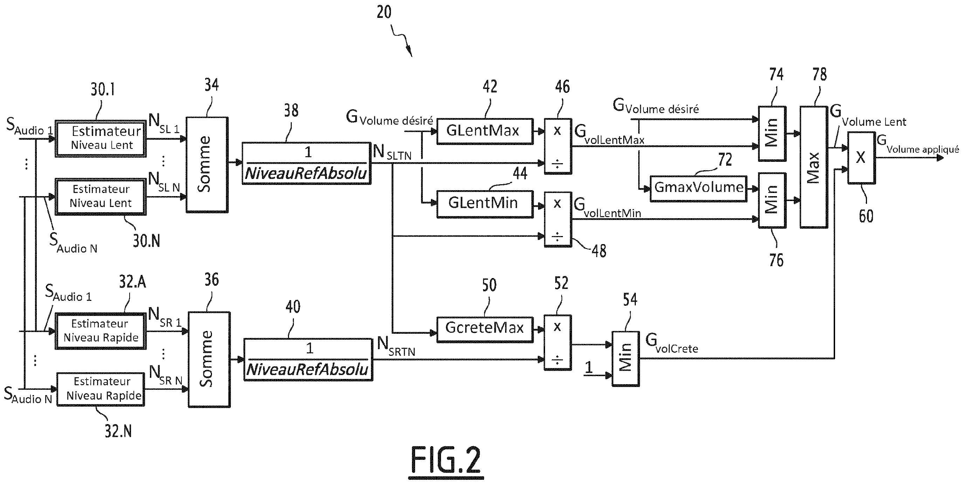

L'installation de restitution sonore 10 illustrée sur la figure 1 comporte plusieurs modules 12.1 à 12.N de production de N signaux audio, tels que des pistes distinctes d'un enregistrement numérique.
Chaque module 12.1 à 12.N de production d'un signal audio est relié à un haut-parleur 14.1 à 14.N au travers d'une unité 15.1 à 15.N d'application d'un gain de volume appliqué noté $G_{Volume\ appliqué}$ et dont la sortie est reliée à une unité d'amplification propre 16.1 à 16.N.
Chaque unité d'application du gain de volume appliqué 15.1 à 15.N est reliée à une unité de gestion du volume 20 pour recevoir le même gain de volume appliqué $G_{Volume\ appliqué}$ à appliquer au signal reçu en entrée.
L'unité de gestion du volume 20 est reliée à un organe de commande 26, tel qu'un potentiomètre rotatif permettant à l'utilisateur de régler un gain de volume désiré notée $G_{Volume\ désiré}$ pour la restitution sonore.
La structure de l'unité de gestion de volume 20 est détaillée sous forme de blocs fonctionnels sur la figure 2.
L'unité de gestion du volume 20 est reliée à la sortie des différentes sources 12.1 à 12.N pour recevoir les signaux audio notés $S_{Audio\ 1}$... $S_{Audio\ N}$.
Pour chaque signal audio, l'unité de gestion de volume 20 comporte un estimateur de niveau lent 30.1 à 30.N et un estimateur de niveau rapide 32.1 à 32.1.
Chaque estimateur de niveau lent 30.1 à 30.N est propre à calculer une variable représentative du niveau sonore lent moyen, constituée de la moyenne des niveaux sonores sur une durée longue de quelques secondes, techniquement comprise 1 et 10 secondes.
Par exemple, chaque estimateur de niveau lent 30.1 à 30.N est propre à effectuer un calcul de la valeur efficace RMS (acronyme de Root Mean Square en anglais) du signal audio pendant la durée retenue, par exemple 5 secondes.
Avantageusement, chaque signal audio $S_{Audio\ 1}$ à $S_{Audio\ N}$ est traité dans un filtre de pondération adapté en fonction de chaque source, afin d'homogénéiser les niveaux sonores perçus par l'utilisateur. Le filtre est par exemple un filtre de pondération iso-sonies (pondération A, B, C ou D) qui est une sorte de modèle psychoacoustique de l'audition humaine.
Le niveau sonore lent est désigné par $N_{SL\ i}$ pour la source audio $S_{audio\ i}$.

Chaque estimateur de niveau rapide 32.1 à 32.N est propre à définir un niveau sonore moyen sur une durée courte, techniquement inférieure à 1 seconde. Ce niveau sonore est par exemple la valeur efficace du signal sur une durée comprise entre 0,1 et 1 seconde.

Le niveau sonore rapide est noté $N_{SR\,i}$ pour la source $S_{Audio\,i}$.

Un sommateur 34, 36 est prévu pour assurer la sommation des niveaux sonores lent et des niveaux sonores rapide entre eux respectivement.

Le résultat de cette somme est multiplié par l'inverse d'un niveau de référence absolu NiveauRefAbsolu dans des blocs 38, 40, afin d'obtenir un niveau sonore lent total normalisé et un niveau sonore rapide total normalisé. Ceux-ci sont notés respectivement $N_{SLTN}$ et $N_{SRTN}$. Ils satisfont les expressions suivantes :

$$N_{SLTN} = Niveau\,Sonore\,Lent\,Total\,Normalisé = \frac{1}{Niveau\,\mathrm{Re}fAbsolu}\sum_{i=1}^{N}N_{SLi}$$

$$N_{SRTN} = Niveau\,Sonore\,Rapide\,Total\,Normalisé = \frac{1}{Niveau\,\mathrm{Re}fAbsolu}\sum_{i=1}^{N}N_{SRi}$$

Le gain du volume désiré $G_{Volume\,désiré}$ obtenu depuis le module de correction 26 est augmenté d'un gain d'amplification $G_{LentMax}$ et $G_{LentMin}$ dans les blocs 42 et 44 respectivement, puis est divisé par le niveau sonore lent total normalisé $N_{SLTN}$ dans des blocs de division 46 et 48 pour obtenir respectivement, un gain de volume lent maximal noté $G_{VolLentMax}$ et un gain de volume lent minimal $G_{VolLentMin}$. Ces gains de volume lent maximal et minimal répondent aux expressions suivantes :

$$G_{VolLentMax} = \frac{1}{N_{SLTN}}\times G_{lentMax}\times G_{Volume\,désiré}$$

$$G_{VolLentMin} = \frac{1}{N_{SLTN}}\times G_{lentMin}\times G_{Volume\,désiré}$$

Parallèlement aux calculs du gain de volume lent maximal et du gain de volume lent minimal, un gain de volume crête noté $G_{VolCrête}$ est déterminé pour limiter l'amplitude des pics sonores lors de la restitution d'un son de forte amplitude, tel qu'une explosion par exemple.

Pour son calcul, le niveau sonore lent total normalisé $N_{SLTN}$ est multiplié par un gain de crête maximal $G_{crêteMax}$ au bloc 50.

Le gain de crête maximal $G_{crêteMax}$ est formé d'un coefficient multiplicatif choisi par exemple parmi deux valeurs, l'une correspondant à un mode de nuit, dans lequel le gain de crête maximal $G_{crêteMax}$ est petit, permettant de réduire les pics sonores, et l'autre correspondant à un niveau de jour, dans lequel le gain de crête maximal $G_{crêteMax}$ est grand, permettant ainsi d'autoriser la reproduction de pics sonores de forte amplitude.

Un bloc 52 assure le calcul d'un coefficient d'extension en amplitude des niveaux sonores des signaux lents par rapport au niveau des signaux rapides. Ce coefficient est formé par le quotient du niveau sonore lent total normalisé $N_{SLTN}$ multiplié par le gain de crête maximal $G_{CrêteMax}$ divisé par le niveau sonore rapide total normalisé $N_{SRTN}$.

En sortie du bloc 54, le gain de volume crête $G_{VolCrête}$ est déterminé comme le minimum entre la valeur 1 et le coefficient d'extension issu du bloc 52. Ainsi, le gain de volume crête $G_{VolCrête}$ satisfait l'expression suivante :

$$G_{VolCrête} = \min\left(1, \frac{G_{crêteMax}\times N_{SLTN}}{N_{SRTN}}\right)$$

Pour le calcul du gain de volume appliqué $G_{Volume}$ appliqué, un bloc 60 assure le produit entre le gain de volume crête $G_{VolCrête}$ précédemment calculé et un gain de volume lent $G_{Volume\,Lent}$ calculé à partir du gain de volume lent maximal $G_{VolLentMax}$ et du gain de volume lent minimal $G_{VolLentMin}$, ainsi que du gain de volume désiré $G_{Volume\,désiré}$ issu de l'organe de commande 26.

A cet effet, le gain de volume désiré $G_{Volume\,désiré}$ est multiplié par un gain maximal de volume noté $G_{maxVolume}$ dans un bloc 72.

Un premier bloc 74 assure la détermination du minimum entre le gain de volume désiré $G_{\text{Volume désiré}}$ et le gain de volume lent maximal $G_{\text{VolLentMax}}$.

Un second bloc 76 assure la détermination du minimum entre le gain de volume désiré $G_{\text{Volume désiré}}$ multiplié par le gain maximal de volume $G_{\text{maxvolume}}$ et le gain de volume lent minimal $G_{\text{VolLentMin}}$.

Le maximum entre ces deux valeurs minimales obtenues est déterminé par un bloc 78 pour former un gain de volume lent $G_{\text{Volume Lent}}$. Ainsi, le gain de volume lent satisfait l'expression suivante :

$$G_{Volume\,Lent} = \max\begin{pmatrix} \min(G_{Volume\,désiré}, G_{VolLentMax}), \\ \min(G_{maxvolume} \times G_{Volume\,désiré}, G_{VolLentMin}) \end{pmatrix}$$

Finalement, le gain de volume appliqué est fourni en sortie du bloc 60 par l'expression suivante :

$$G_{Volume\,appliqué} = G_{VolCrête} \times G_{Volume\,Lent}$$

On comprend que le gain de volume lent $G_{\text{Volume Lent}}$ permet de maintenir le niveau sonore entre les limites haute et basse désirées fixées par l'intermédiaire des gains $G_{\text{LentMax}}$ et $G_{\text{LentMin}}$ dans les blocs 42 et 44 respectivement. En effet, pour un niveau sonore trop élevé, le gain de volume lent $G_{\text{Volume Lent}}$ prend la valeur donnée par $G_{\text{VolLentMax}}$, qui est d'autant plus petit que le niveau sonore est trop élevé. Par contre, si le niveau sonore est trop faible, le gain de volume lent $G_{\text{Volume Lent}}$ prend la valeur donnée par $G_{\text{VolLentMin}}$ dans la limite du gain donné par $G_{\text{maxVolume}}$ X $G_{\text{Volume désiré}}$ afin de limiter à une valeur maximale désirée le gain de volume par rapport au $G_{\text{Volume désiré}}$.

## Revendications

1. Procédé d'adaptation d'un gain de volume ($G_{\text{Volume appliqué}}$) appliqué par un amplificateur à au moins un signal audio ($S_{\text{Audio 1}}$ à $S_{\text{Audio N}}$) à reproduire, en fonction d'un gain de volume désiré ($G_{\text{Volume désiré}}$) sélectionné par un utilisateur, le procédé étant exécuté par l'amplificateur et comportant des étapes de :

   - calculer un niveau sonore lent total normalisé ($N_{\text{SLTN}}$) à partir du ou des signaux audio ($S_{\text{Audio 1}}$ à $S_{\text{Audio N}}$) à reproduire ;
   - calculer un gain de volume lent maximal ($G_{\text{VolLentMax}}$) et un gain de volume lent minimal ($G_{\text{VolLentMin}}$) comme le quotient du produit du gain de volume désiré ($G_{\text{Volume désiré}}$) par un gain lent maximal ($G_{\text{LentMax}}$) respectivement par un gain lent minimal ($G_{\text{LentMin}}$) divisé par le niveau sonore lent total normalisé ($N_{\text{SLTN}}$) ;
   - déterminer un premier minimum entre le gain de volume désiré ($G_{\text{volume désiré}}$) et le gain de volume lent maximal ($G_{\text{VolLentMax}}$) ;
   - déterminer un second minimum entre le gain de volume désiré ($G_{\text{Volume désiré}}$) multiplié par un gain de volume maximal ($G_{\text{maxVolume}}$) et le gain de volume lent minimal ($G_{\text{volLentMin}}$) ;
   - déterminer, en tant que gain de volume lent ($G_{\text{Volume Lent}}$), le maximum des premier et second minima précédemment déterminés ;
   - calculer le gain de volume appliqué ($G_{\text{Volume appliqué}}$) en fonction du gain de volume lent ($G_{\text{Volume Lent}}$).

2. Procédé d'adaptation selon la revendication 1, **caractérisé en ce que** l'étape de calcul du niveau sonore lent total normalisé ($N_{\text{SLTN}}$) comporte, pour le ou chaque signal audio ($S_{\text{Audio 1}}$ à $S_{\text{Audio N}}$) à reproduire, le calcul d'un niveau sonore lent ($N_{\text{SL 1}}$, ..., $N_{\text{SL N}}$) propre au signal audio, comme la moyenne des niveaux du signal audio de chaque source sur une durée longue.

3. Procédé selon la revendication 2, **caractérisé en ce qu'**il comporte au moins deux signaux audio ($S_{\text{Audio 1}}$ à $S_{\text{Audio N}}$) à reproduire, et **en ce que** le niveau sonore lent total normalisé ($N_{\text{SLTN}}$) est une fonction de chacun des niveaux sonores lents ($N_{\text{SL 1}}$, ..., $N_{\text{SL N}}$).

4. Procédé selon la revendication 2 ou 3, **caractérisé en ce que** la durée longue est supérieure à 1 seconde.

5. Procédé selon l'une quelconque des revendications précédentes, **caractérisé en ce que** le gain de volume appliqué ($G_{\text{Volume appliqué}}$) est le produit du gain de volume lent ($G_{\text{Volume Lent}}$) par un gain de volume crête ($G_{\text{VolCrête}}$) de valeur

inférieure ou égale à 1 dépendant des fluctuations du niveau sonore du ou de chaque signal sonore ($S_{Audio\ 1}$ à $S_{Audio\ N}$) sur une durée courte strictement inférieure à la durée longue.

6. Procédé selon la revendication 5, **caractérisé en ce que** le calcul du gain de volume crête ($G_{VolCrête}$) comporte les étapes de :

   - calculer un niveau sonore rapide total normalisé ($N_{SRTN}$) à partir du ou des signaux ($S_{Audio\ 1}$ à $S_{Audio\ N}$) à reproduire
   - calculer un coefficient d'extension égal au quotient du produit du niveau sonore lent total normalisé ($N_{SLTN}$) par un gain de crête maximal ($G_{Crête\ Max}$) divisé par le niveau sonore rapide total normalisé ($N_{SRTN}$)
   - calculer le gain de volume crête ($G_{VolCrête}$) comme le minimum du coefficient d'extension et de la valeur 1.

7. Procédé d'adaptation selon la revendication 6, **caractérisé en ce que** l'étape de calcul du niveau sonore rapide total normalisé ($N_{SRTN}$) comporte, pour le ou chaque signal audio ($S_{Audio\ 1}$ à $S_{Audio\ N}$) à reproduire, le calcul d'un niveau sonore rapide ($N_{SR\ 1}$, ..., $N_{SR\ N}$) propre à chaque signal audio, comme la moyenne des niveaux du signal audio de la source sur la durée courte.

8. Procédé selon la revendication 7, **caractérisé en ce qu'**il comporte au moins deux signaux audio ($S_{Audio\ 1}$ à $S_{Audio\ N}$) à reproduire et, **en ce que** le niveau sonore rapide total normalisé ($N_{SRTN}$) est une fonction de chacun des niveaux sonores rapides ($N_{SR\ 1}$ à $N_{SR\ N}$).

9. Procédé selon les revendications 5 à 8, **caractérisé en ce que** la durée courte est inférieure à 1 seconde.

10. Amplificateur comportant des moyens d'adaptation d'un gain de volume appliqué ($G_{Volume\ appliqué}$) à au moins un signal audio ($S_{Audio\ 1}$ à $S_{Audio\ N}$) à reproduire en fonction d'un gain de volume désiré ($G_{Volume\ désiré}$) sélectionné par un utilisateur comportant :

   - des moyens de calcul d'un niveau sonore lent total normalisé ($N_{SLTN}$) à partir du ou des signaux audio ($S_{Audio\ 1}$ à $S_{Audio\ N}$) à reproduire ;
   - des moyens de calcul d'un gain de volume lent maximal ($G_{VolLentMax}$) et d'un gain de volume lent minimal ($G_{VolLentMin}$) comme le quotient du produit du gain de volume désiré ($G_{Volume\ désiré}$) par un gain lent maximal ($G_{LentMax}$) respectivement par un gain lent minimal ($G_{LentMin}$) divisé par le niveau sonore lent total normalisé ($N_{SLTN}$) ;
   - des moyens pour déterminer un premier minimum entre le gain de volume désiré ($G_{volume\ désiré}$) et le gain de volume lent maximal ($G_{VolLentMax}$) ;
   - des moyens pour déterminer un second minimum entre le gain de volume désiré ($G_{Volume\ désiré}$) multiplié par un gain de volume maximal ($G_{maxVolume}$) et le gain de volume lent minimal ($G_{volLentMin}$) ;
   - des moyens pour déterminer, en tant que gain de volume lent ($G_{Volume\ Lent}$), le maximum des premier et second minima précédemment déterminés ;
   - des moyens pour calculer le gain de volume appliqué ($G_{Volume\ appliqué}$) en fonction du gain de volume lent ($G_{Volume\ Lent}$).

## Patentansprüche

1. Verfahren zur Anpassung einer Lautstärkenverstärkung ($G_{angewendete\ Lautstärke}$), welche durch einen Verstärker auf mindestens ein zu reproduzierendes Audiosignal ($S_{Audio\ 1}$ bis $S_{Audio\ N}$) angewendet wird, in Abhängigkeit von einer gewünschten Lautstärkenverstärkung ($G_{gewünschte\ Lautstärke}$), welche durch einen Nutzer gewählt wird, wobei das Verfahren durch den Verstärker ausgeführt wird und aufweist die Schritte des:

   - Berechnens eines normalisierten gesamten langsamen akustischen Pegels ($N_{SLTN}$) ausgehend von dem oder den zu reproduzierenden Audiosignalen ($S_{Audio\ 1}$ bis $S_{Audio\ N}$),
   - Berechnens einer maximalen langsamen Lautstärkenverstärkung ($G_{VolLangsamMax}$) und einer minimalen langsamen Lautstärkenverstärkung ($G_{VolLangsamMin}$) als der Quotient des Produkts der gewünschten Lautstärkenverstärkung ($G_{gewünschte\ Lautstärke}$) mit einer maximalen langsamen Verstärkung ($G_{LangsamMax}$) bzw. mit einer minimalen langsamen Verstärkung ($G_{LangsamMin}$) geteilt durch den normalisierten gesamten langsamen akustischen Pegel (NSLTN),
   - Bestimmens eines ersten Minimums zwischen der gewünschten Lautstärkenverstärkung ($G_{gewünschte\ Lautstärke}$)

und der maximalen langsamen Lautstärkenverstärkung ($G_{VolLangsamMax}$),
- Bestimmens eines zweiten Minimums zwischen der gewünschten Lautstärkenverstärkung ($G_{gewünschte\ Lautstärke}$), welche mit der maximalen Lautstärkenverstärkung ($G_{maxLautstärke}$) multipliziert wird, und der minimalen langsamen Lautstärkenverstärkung ($G_{VolLangsamMin}$),
- Bestimmens des Maximums von dem ersten und dem zweiten Minimum, welche zuvor bestimmt wurden, als die langsame Lautstärkenverstärkung ($G_{langsame\ Lautstärke}$),
- Berechnens der angewendeten Lautstärkeverstärkung ($G_{angewendete\ Lautstärke}$) in Abhängigkeit von der langsamen Lautstärkenverstärkung ($G_{langsame\ Lautstärke}$).

2. Verfahren zur Anpassung gemäß dem Anspruch 1, **gekennzeichnet dadurch, dass** der Schritt des Berechnens des normalisierten gesamten langsamen akustischen Pegels ($N_{SLTN}$) aufweist, für das oder jedes zu reproduzierende Audiosignal ($S_{Audio\ 1}$ bis $S_{Audio\ N}$), die Berechnung eines langsamen akustischen Pegels ($N_{SL\ 1}$, ..., $N_{SL\ N}$), welcher für das Audiosignal charakteristisch ist, als den Mittelwert des Pegels des Audiosignals jeder Quelle über eine lange Dauer.

3. Verfahren gemäß dem Anspruch 2, **gekennzeichnet dadurch, dass** es mindestens zwei zu reproduzierende Audiosignale ($S_{Audio\ 1}$ bis $S_{Audio\ N}$) aufweist, und dadurch, dass der normalisierte gesamte langsame akustische Pegel ($N_{SLTN}$) eine Funktion von jedem von den langsamen akustischen Pegel ($N_{SL\ 1}$, ..., $N_{SL\ N}$) ist.

4. Verfahren gemäß dem Anspruch 2 oder 3, **gekennzeichnet dadurch, dass** die lange Dauer größer als eine Sekunde ist.

5. Verfahren gemäß irgendeinem der vorhergehenden Ansprüche, **gekennzeichnet dadurch, dass** die angewendete Lautstärkeverstärkung ($G_{angewendete\ Lautstärke}$) das Produkt der langsamen Lautstärkenverstärkung ($G_{langsame\ Lautstärke}$) mit einer Spitzen-Lautstärkenverstärkung ($G_{VolSpitze}$) von einem Wert, welcher kleiner oder gleich 1 ist, in Abhängigkeit von Fluktuationen des Geräuschpegels von dem oder jedem akustischen Signal ($S_{Audio\ 1}$ bis $S_{Audio\ N}$) während einer kurzen Dauer, welche echt kleiner ist als die lange Dauer, ist.

6. Verfahren gemäß dem Anspruch 5, **gekennzeichnet dadurch, dass** die Berechnung der Spitzen-Lautstärkenverstärkung ($G_{VolSpitze}$) aufweist die Schritt des:

- Berechnens eines normalisierten gesamten schnellen akustischen Pegels ($N_{SRTN}$) ausgehend von dem oder den zu reproduzierenden Audiosignalen ($S_{Audio\ 1}$ bis $S_{Audio\ N}$),
- Berechnens eines Erweiterungskoeffizienten, welcher gleich dem Quotient des Produkts des normalisierten gesamten langsamen akustischen Pegels ($N_{SLTN}$) mit einer maximalen Spitzenverstärkung ($G_{Spitze\ Max}$) geteilt durch den normalisierten gesamten schnellen akustischen Pegel ($N_{SRTN}$) ist,
- Berechnens der Spitzen-Lautstärkenverstärkung ($G_{VolSpitze}$) als das Minimum des Erweiterungskoeffizienten und des Werts 1.

7. Verfahren zur Anpassung gemäß dem Anspruch 6, **gekennzeichnet dadurch, dass** der Schritt des Berechnens des normalisierten gesamten schnellen akustischen Pegels ($N_{SRTN}$) aufweist, für das oder jedes zu reproduzierende Audiosignal ($S_{Audio\ 1}$ bis $S_{Audio\ N}$), das Berechnen eines schnellen akustischen Pegels ($N_{SR\ 1}$, ..., $N_{SR\ N}$), welcher charakteristisch für jedes Audiosignal ist, als den Mittelwert des Pegels des Audiosignals der Quelle während der kurzen Dauer.

8. Verfahren gemäß dem Anspruch 7, **gekennzeichnet dadurch, dass** es mindestens zwei zu reproduzierende Audiosignale ($S_{Audio\ 1}$ bis $S_{Audio\ N}$) aufweist, und dadurch, dass der normalisierte gesamte schnelle akustische Pegel ($N_{SRTN}$) eine Funktion von jedem von den schnellen akustischen Pegel ($N_{SR\ 1}$, ..., $N_{SR\ N}$) ist.

9. Verfahren gemäß den Ansprüchen 5 bis 8, **gekennzeichnet dadurch, dass** die kurze Dauer kleiner als 1 Sekunde ist.

10. Verstärker, aufweisend Mittel zur Anpassung einer auf mindestens ein zu reproduzierendes Audiosignal ($S_{Audio\ 1}$ bis $S_{Audio\ N}$) angewendeten Lautstärkenverstärkung ($G_{angewendete\ Lautstärke}$) in Abhängigkeit von einer gewünschten Lautstärkenverstärkung ($G_{gewünschte\ Lautstärke}$), welche durch einen Nutzer gewählt wird, aufweisend:

- Mittel zum Berechnen eines normalisierten gesamten langsamen akustischen Pegels ($N_{SLTN}$) ausgehend von dem oder den zu reproduzierenden Audiosignalen ($S_{Audio\ 1}$ bis $S_{Audio\ N}$),
- Mittel zum Berechnen einer maximalen langsamen Lautstärkenverstärkung ($G_{VolLangsamMax}$) und einer minimalen langsamen Lautstärkenverstärkung ($G_{VolLangsamMin}$) als der Quotient des Produkts der gewünschten Lautstärkenverstärkung ($G_{gewünschte\ Lautstärke}$) mit einer maximalen langsamen Verstärkung ($G_{LangsamMax}$) bzw. mit einer minimalen langsamen Verstärkung ($G_{LangsamMin}$) geteilt durch den normalisierten gesamten langsamen akustischen Pegel (NSLTN),

- Mittel zum Bestimmen eines ersten Minimums zwischen der gewünschten Lautstärkenverstärkung ($G_{gewünschte\ Lautstärke}$) und der maximalen langsamen Lautstärkenverstärkung ($G_{VolLangsamMax}$),
- Mittel zum Bestimmen eines zweiten Minimums zwischen der gewünschten Lautstärkenverstärkung ($G_{gewünschte\ Lautstärke}$), welche mit der maximalen Lautstärkenverstärkung ($G_{maxLautstärke}$) multipliziert wird, und der minimalen langsamen Lautstärkenverstärkung ($G_{VolLangsamMin}$),
- Mittel zum Bestimmen des Maximums von dem ersten und dem zweiten Minimum, welche zuvor bestimmt wurden, als die langsame Lautstärkenverstärkung ($G_{langsame\ Lautstärke}$),
- Mittel zum Berechnen der angewendeten Lautstärkeverstärkung ($G_{angewendete\ Lautstärke}$) in Abhängigkeit von der langsamen Lautstärkenverstärkung ($G_{langsame\ Lautstärke}$).

## Claims

1. A method for adapting a volume gain ($G_{Volume\ appliqué}$) applied by an amplifier to at least one audio signal ($S_{Audio\ 1}$ to $S_{Audio\ N}$) to be reproduced, according to a desired volume gain ($G_{Volume\ desire}$) selected by a user, the method being implemented by an amplifier and including the following steps:

   - calculating a standardized total slow sound level ($N_{SLTN}$) from the audio signal(s) to be reproduced ($S_{Audio\ 1}$ to $S_{Audio\ N}$);
   - calculating a maximum slow volume gain ($G_{VolLentMax}$) and a minimum slow volume gain ($G_{volLentMin}$) as the quotient of the product of the desired volume gain ($G_{Volume\ desire}$) by a maximum slow gain ($G_{LentMax}$), respectively by a minimum slow gain ($G_{LentMin}$), divided by the standardized total slow sound level ($N_{SLTN}$);
   - determining a first minimum out of the desired volume gain ($G_{volume\ desire}$) and the maximum slow volume gain ($G_{VolLentMax}$);
   - determining a second minimum out of the desired volume gain ($G_{Volume\ desire}$) multiplied by a maximum volume gain ($G_{maxVolume}$) and the minimum slow volume gain ($G_{volLentMin}$);
   - determining, as a slow volume gain ($G_{Volume\ Lent}$), the maximum of the first and second previously determined minima;
   - calculating the volume gain applied ($G_{Volume\ appliqué}$) according to the slow volume gain ($G_{Volume\ Lent}$).

2. The adaptation method according to claim 1, **characterized in that** the step for calculating the standardized total slow sound level ($N_{SLTN}$) includes, for the or each audio signal ($S_{Audio\ 1}$ to $S_{Audio\ N}$) to be reproduced, calculating a slow sound level ($N_{SL\ 1}$, ..., $N_{SL\ N}$) specific to the audio signal, such as the average of the levels of the audio signal of each source over a long duration.

3. The method according to claim 2, **characterized in that** it includes at least two audio signals ($S_{Audio\ 1}$ to $S_{Audio\ N}$) to be reproduced, and the standardized total slow sound level ($N_{SLTN}$) is a function of each of the slow sound levels ($N_{SL\ 1}$, ..., $N_{SL\ N}$).

4. The method according to claim 2 or 3, **characterized in that** the long duration is greater than 1 second.

5. The method according to any one of the preceding claims, **characterized in that** the applied volume gain ($G_{Volume\ appliqué}$) is the product of the slow volume gain ($G_{Volume\ Lent}$) multiplied by a peak volume gain ($G_{VolCrête}$) having a value lower than or equal to 1 depending on fluctuations of the sound level of the or each sound signal ($S_{Audio\ 1}$ to $S_{Audio\ N}$) over a short duration strictly shorter than the long duration.

6. The method according to claim 5, **characterized in that** the calculation of the peak volume gain ($G_{VolCrête}$) includes the following steps:

   - calculating a standardized total fast sound level ($N_{SRTN}$) from the signal(s) to be reproduced ($S_{Audio\ 1}$ to $S_{Audio\ N}$);
   - calculating an expansion coefficient equal to the quotient of the product of the standardized total slow sound level ($N_{SLTN}$) multiplied by a maximum peak gain ($G_{Crête\ Max}$) divided by the standardized total fast sound level ($N_{SRTN}$)
   - calculating the peak volume gain ($G_{VolCrête}$) as the minimum of the expansion coefficient and the value 1.

7. The adaptation method according to claim 6, **characterized in that** the step for calculating the standardized total fast sound level ($N_{SRTN}$) includes, for the or each audio signal ($S_{Audio\ 1}$ to $S_{Audio\ N}$) to be reproduced, calculating a fast sound level ($N_{SR\ 1}$, ..., $N_{SR\ N}$) specific to each audio signal, such as the average of the levels of the audio signal of the source over the short duration.

8. The method according to claim 7, **characterized in that** it includes at least two audio signals ($S_{Audio\ 1}$ to $S_{Audio\ N}$) to be reproduced, and the standardized total fast sound level ($N_{SRTN}$) is a function of each of the slow sound levels ($N_{SR\ 1}$ to $N_{SR\ N}$).

9. The method according to claims 5 to 8, **characterized in that** the short duration is less than 1 second.

10. An amplifier including means for adapting a volume gain applied ($G_{Volume\ appliqué}$) to at least one audio signal ($S_{Audio\ 1}$ to $S_{Audio\ N}$) to be reproduced, according to a desired volume gain ($G_{Volume\ desire}$) selected by a user, including:

   - means for calculating a standardized total slow sound level ($N_{SLTN}$) from the audio signal(s) to be reproduced ($S_{Audio\ 1}$ to $S_{Audio\ N}$);
   - means for calculating a maximum slow volume gain ($G_{VolLentMax}$) and a minimum slow volume gain ($G_{volLentMin}$) as the quotient of the product of the desired volume gain ($G_{volume\ désiré}$) by dividing a maximum slow gain ($G_{LentMax}$) or respectively a minimum slow gain ($G_{LentMin}$) by the standardized total slow sound level (NSLTN);
   - means for determining a first minimum out of the desired volume gain ($G_{volume\ desire}$) and the maximum slow volume gain ($G_{VolLentMax}$);
   - means for determining a second minimum out of the desired volume gain ($G_{Volume\ desire}$) multiplied by a maximum volume gain ($G_{maxVolume}$) and the minimum slow volume gain ($G_{volLentMin}$) ;
   - means for determining, as a slow volume gain ($G_{Volume\ Lent}$), the maximum of the first and second previously determined minima;

   - means for calculating the volume gain applied ($G_{Volume\ appliqué}$) according to the slow volume gain ($G_{Volume\ Lent}$).

10

14.1

-12.1-        -15.1-        -16.1-

⋮            ⋮            ⋮            ⋮

-12.N-        -15.N-        -16.N-

14.N

$G_{\text{Volume appliqué}}$

$G_{\text{Volume désiré}}$        -20-

26

# FIG.1

FIG.2

## RÉFÉRENCES CITÉES DANS LA DESCRIPTION

**Documents brevets cités dans la description**

- US 5666430 A
- US 6195438 B
- US 2014369527 A